# EUROPEAN PATENT APPLICATION

(11) **EP 4 170 226 A1**
(43) Date of publication of application: **26.04.2023**
(21) Application number: 22202135.4
(22) Date of filing: 18.10.2022
(51) Int. Cl.: F21S 4/28, F21V 29/76, F21V 29/83, F21S 8/06, F21Y 115/10

(54) **A HEAT SINK AND A LIGHTING FIXTURE**

(30) Priority: 20.10.2021 SE 2151277
(71) Applicant: Uvivo AB, 93133 Skellefteå (SE)
(72) Inventor: WIKSTRÖM, Erik, 93133 Skellefteå (SE)
(74) Representative: Zacco Sweden AB

(57) **Abstract**

The invention relates to a heat sink (1) made in profile shape of metal through extrusion and comprising a plurality of cooling fins (2), formed by slicing, a base (3) with a first and a second side (4, 5), wherein the cooling fins are disposed on the first side (4), and a semiconductor device (6) is mounted on the second side (5), a channel (8:1, 8:2) disposed in the base (3) allowing a medium to flow between the first and the second side of the base. According to the invention, the extent of the base (3) is defined in its width direction by a plurality of profile elements (10:1, 10:2, 10:3) travelling in parallel and mutually spaced, which between them delimit a least one medium-permeable channel (8:1, 8:2), whereby the cooling fins (2) form a web joining the profile elements. 14. The invention also relates to a lighting fixture (20).

## Description

### TECHNICAL FIELD

The invention relates to a heat sink for removing heat that is produced by semiconductors such as light-emitting diodes, LEDs, microprocessors CPUs or similar electronic devices according to the preamble of claim 1. The invention also relates to a lighting fixture intended to be disposed, directly or indirectly, onto a ceiling in a building according to claim 12

### BACKGROUND

Heat sinks are components that are configured to transfer energy from a unit generating heat, e.g. semiconductor units, including light-emitting diodes ("LEDs"), central processing units ("CPU"), graphic processing units ("GPU") and other electronic units. Usually, the ambient atmosphere is used for heat exchange with the heat sink. Heat sinks using a fluid or gas for facilitating heat exchange with the ambient environment are also known.

For lighting applications, light-emitting diodes or so-called LEDs are particularly energy-efficient and tend to have a long operating life. Light-emitting diodes can be used in many different lighting structures to replace conventional neon or fluorescent lighting. More specifically, LED lighting units can be used as street lighting, car headlights or rear lights, traffic and/or railway signals, advertising signs etc. Another field of application is lighting fixtures that provide artificial lighting in greenhouses for different types of cultures. A common feature for these units is that they can be exposed to natural environmental conditions with high ambient temperatures, especially in the daytime in warm climates and in the summer. When the heat sink is combined with the self-generated heat from the light-emitting diodes in the unit, the resultant temperature in the unit can impair the LED performance. Therefore there is a need for heat sinks that in an efficient manner enable heat removal from LEDs and similar semiconductor components. The type of LED lightings mentioned above usually apply so-called LED PCBs (Printed Circuit Board), i.e. semiconductor elements that in principle consist of a cluster of light-emitting diodes that are packaged on a circuit board. In the following, this type of semiconductor elements for lighting purposes are termed LED-PCBs.

So-called "slicing" is a manufacturing method involving that substantially thin cooling fins are planed out from a block of metal with good heat conduction, which block is usually made through extrusion. The fins are planed by means of a special blade tool and are angled from of a remaining base of the metal block. As both the fins and the base are shaped in one piece, a heat sink is obtained with very good heat removal properties and a high thermal performance. The cooling fins 2 are formed in block-slice pattern on the base portion 3 and can have a thickness of between 50µm and 2 mm. Extrusion involves the material being pressed through a nozzle, a so-called matrix. The configuration of the matrix determines the shape of the profile. Objects that are extruded are usually elongated and have the same cross-sectional area along the entire length.

Generally, an increased surface area of the heat sink provides improved component cooling, but only on condition that stationary boundary layers of the cooling medium can be avoided and that adjoining cooling fins do not obstruct a passing air or medium flow.

From US 2015/009822 A1, we know a heat sink comprising a plurality of cooling fins formed by slicing, a base portion with a first and a second side, wherein sliced cooling fins are located on the first side. On the second side, a semiconductor device is mounted. For efficient heat removal, the base portion comprises at least one channel that provides a gas flow between the first side and the second side. Though this prior art heat sink has proved to be well-functioning, there is always an effort to further improve and make heat removal and design more efficient for this type of heat sinks.

### SUMMARY OF THE INVENTION

An object of this invention is thus to obtain a new heat sink with improved heat-removing properties. First of all, effort is made to be able to obtain a heat sink, the cooling surface of which, exposed to the surroundings via the cooling fins, can be increased simultaneously with the outer dimensions and measure of the cooling fins can be maintained or reduced compared with prior art heat sinks. Thus, it is desirable to obtain a new type of compact and efficient heat sink. This first object of the invention is resolved by a heat sink having the features and characteristics stated in claim 1.

Another object of the invention is to obtain a lighting fixture intended to be disposed directly or indirectly onto a ceiling in a building and a fixture that can provide lighting for various types of purposes, not least artificial lighting in greenhouses for various types of cultures, enabling LEDs to be useful in warm climates in greenhouses. This second object of the invention is resolved by a lighting fixture having the features and characteristics stated in claim 12.

The insight providing the basis for the invention, that improved heat removal properties and increased gas or medium flows through the heat sink being obtained if the base could be arranged with a construction-wise "open structure" with a structural configuration, with which the extent of the base in its width direction is defined by a plurality of profile elements travelling in parallel and mutually spaced that between them delimit at least one medium-permeable channel, whereby the cooling fins form a cohesive web by the profile elements. Such a channel has the advantage, among other things, of being able to travel along the entire length of the heat sink.

### DESCRIPTION OF FIGURES

In the following, the invention is described in detail with reference to the accompanying drawings, in which;
Fig. 1 shows a perspective view obliquely from above of a heat sink with a medium-permeable open base structure, wherein the cooling fins form a cohesive bridging web of the base part according to the invention,
Fig. 2A shows a side view straight from the front of the heat sink in Fig. 1,
Fig. 2B shows a view from below of the heat sink in Fig. 1,
Fig. 3 shows a perspective view obliquely from below of an alternative embodiment of the invention in the form of a lighting fixture, in which a heat sink with open basis structure according to the invention is equipped with a bracket structure encompassing the heat sink and a number of LED-PCBs mounted on the underside of the heat sink,
Fig. 4 shows a perspective view from below of the lighting fixture in Fig. 3,
Fig. 5 shows a perspective view obliquely from below of a cutout portion of a heat sink according to the invention, equipped with a plurality of undercut tracks obtained through profiling, intended for mountable interaction with a bracket structure included in the embodiment of the invention shown in Fig. 3.

### DESCRIPTION OF EMBODIMENTS

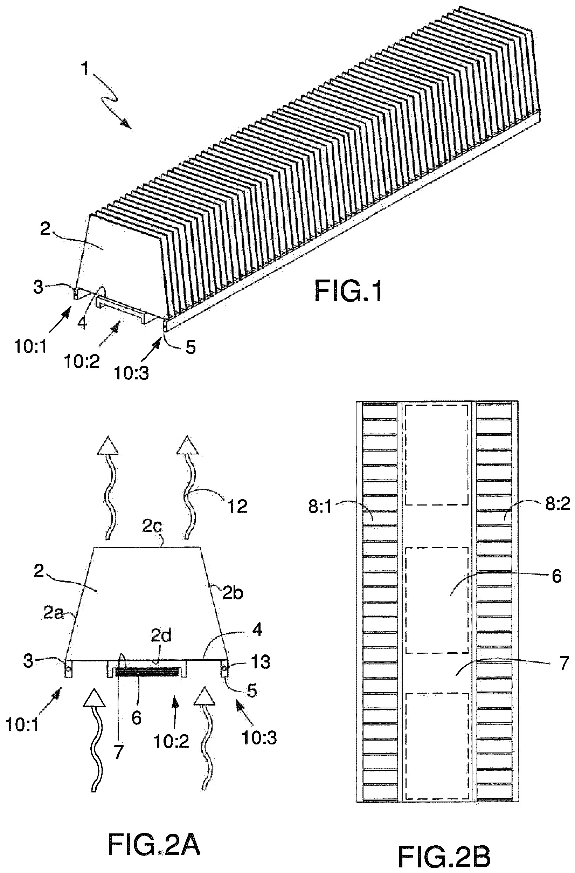

Fig. 1 shows a perspective view of a heat sink 1 providing a gas flow through the heat sink and being capable of forming part of a lighting fixture 20 according to the invention.

With reference to Figs 2A and 2B, the heat sink 1 is made in profile shape out of metal by extrusion and comprising a plurality of cooling fins 2 formed by slicing, a base 3 with a first side 4 and a second side 5, wherein the cooling fins 2 are located on the first side. The heat sink 1 can suitably be made through extrusion of aluminum, copper or similar extrudable material with good heat removal properties.

A semiconductor device 6 consisting of a series of LED-PCBs is mounted on the second side 5. A first and a second channel 8:1, 8:2 disposed in the base 3 allow a medium, such as a gaseous medium in the form of air in the ambient atmosphere, to flow between the first 4 and the second side 5 of the base 3. Said first and second channels 8:1, 8:2 travel mutually spaced and in parallel with each other along the entire length of the heat sink 1.

The first and the second channels 8:1, 8:2 thus form connections between said sides 4, 5 of the base 3 to allow a gas flow 12 to pass through the base from the second side 5, on which the semiconductor devices 6 are mounted onto the first side 4 of the base, which is provided with cooling fins 2. The massive gas flow 12 hereby obtained through, in terms of area, the relatively very large channels 8:1, 8:2 (cooling channels) and further through the spacing delimited between the abutting cooling fins 2 offers a very good heat removal of the present heat sink 1.

According to the invention, the base 3 is configured with an open structure, enabling arrangement of said elongated first and second channels 8:1, 8:2 travelling in parallel, which provide a relatively large flow area and therefore a high medium flow.

As most clearly appears from Figs 2A and 2b, the extent of the base 3 in its width direction is defined by a plurality (three) of profile elements 10:1, 10:2, 10:3 travelling in parallel and mutually spaced, which between them delimit said parallel channels 8:1, 8:2. According to the invention, the end edge portion, facing the base 3, of the cooling fins 2 forms a cohesive web for the profile elements 10:1, 10:2, 10:3, which web partly bridges the distance between the profile elements and partly joins these mutually.

It should be understood that according to the invention in an alternative embodiment (not shown), the base 3 could only comprise two profile elements, which between them delimit a single medium-permeable channel.

As appears from Fig. 2A, the central profile element 10:2 of the base 3, viewed in the width direction, is wider than the other two outer profile elements 10:1, 10:3. The semiconductor device 6 is mounted on an underside of the central wider profile element 10:2. To obtain a discrete and protected assembly, the wider profile element 10:2 has a U-shaped cross section to thereby form a kind of bearing rail for the semiconductor device 6 with an open channel 7 turned away from the cooling fins 2, in which said semiconductor device 6 can be mounted in a recessed manner, which is illustrated in Fig. 2B.

Also with reference to Figs 1 and 2B, it appears how the sliced cooling fins 2 are configured to be substantially perpendicular and thus transverse to the longitudinal axis of the base 3 of the heat sink 1.

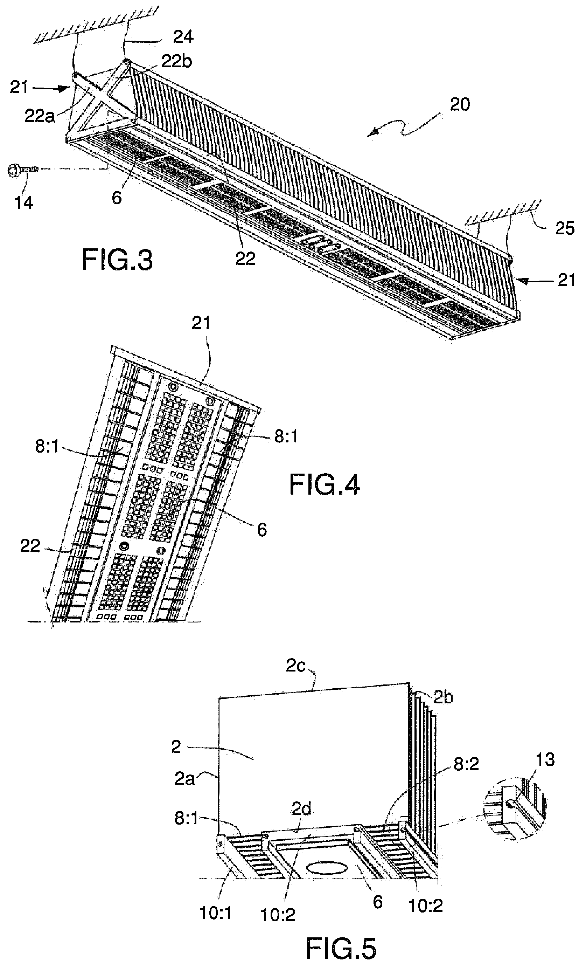

With reference to Fig. 2A and Fig. 5, it further appears that each of the two outer narrower profile elements 10:1, 10:3, which viewed as volume elements have a parallellepipedic shape with a rectangular cross section profile, the height of which exceeds the width of the profile element, and that the central wider profile element 10:2 is disposed between the two outer narrower profile elements 10:1, 10:3 in such a manner that said pair of parallel channels 8:1, 8:2 (cooling channels) travelling along the entire length of the heat sink 1 are delimited between said respective profile elements.

With reference to the embodiment in Fig. 5, the cooling fins 2 can have a four-sided main surface, which in both height and width direction is delimited by parallel sides 2a, 2b, 2c, 2d. Fig. 2A shows an alternative preferred embodiment, in which the cooling fins 2 in the width direction are delimited by sides 2a, 2b tilting inwards in such a manner that the cooling fins 2 are narrower at their free end than at the end facing the base 3.

As shown in detail enlargement of the embodiment in Fig. 5, but also indicated in the embodiment in Fig. 2A, the base 3 can be arranged with one or a plurality of tracks 13, undercut through profiling, each of which is intended to form an engagement part for a fastener 14 such as a screw means or the like. Said undercut tracks 13 are advantageously disposed in at least each of the narrower outer profile elements 10:1, 10:3 of the heat sink 1.

In an alternative embodiment of the invention shown in Fig. 3 and Fig. 4, the heat sink 1 according to the invention described above can form part of a lighting fixture 20 intended, directly or indirectly via suspension means 24, to be disposed onto a ceiling 25 in a building to provide a downward light by means of semiconductors 6 in the form of LED-PCBs.

As a non-limiting example, such lighting fixture 20 could be used for creating artificial lighting in a greenhouse for culture particularly of vegetables despite the very high temperatures that may occur in such greenhouses, especially at the level of the ceiling.

The lighting fixture 20 comprises a bracket structure generally denoted 21, which is arranged, in a supporting manner, to encompass a plurality of side edge portions of the heat sink according to the invention to thereby protect the heat sink 1 with its open base structure 3 from bumps and impacts. The combination of the heat sink and the bracket structure involves a number of production advantages. For example, the heat sink can be manufactured in a significantly more cost-efficient way relative to the size with little material consumption, as the need for self-sustained structural properties of the heat sink can be reduced .

The bracket structure 21 comprises in detail the side pieces 22, which are disposed on either short side of the heat sink 1, and a plurality of elongated connection elements 23, which, joining said respective side pieces 22, are arranged to extend in the longitudinal direction of the heat sink. Said side pieces 22 are mounted in the base portion 3 of the heat sink 1 via screw means or the like in the fasteners 14 accommodated in the undercut tracks 13.

In an embodiment of the invention, each side piece 22 is configured with two transverse substantially platform-like side arms 22a, 22b, and each elongated connection element 23 is configured as, viewed in the cross section, V-shaped angle brace of relatively low material thickness and with suitably configured mounting plates (not shown) at its ends. The connection elements 23 are arranged to extend along the long side edges of the heat sink 1, whereby said angle brace, at its ends, is mutually joined with said side pieces 22 via the fasteners 14 and said mounting plates.

In an embodiment of the invention, the bracket structure can simultaneously form part of said suspension means 24 for suspension of the lighting fixture 20 directly or indirectly in a ceiling 25 in a building and similar roof structures.

## Claims

1. A heat sink (1) made in profile shape of metal by extrusion and comprising a plurality of cooling fins (2), formed by slicing, a base (3) with a first and a second side (4, 5), wherein the cooling fins are disposed on the first side (4), and a semiconductor device (6) is mounted on the second side (5), a channel (8:1, 8:2) arranged in the base (3), which channel allows flowing of a medium between the first and the second side of the base, **characterized in** the extent of the base (3) in its width direction being defined by a plurality of profile elements (10:1, 10:2, 10:3) travelling in parallel and mutually spaced, which between them delimit at least one medium-permeable channel (8:1, 8:2), wherein the cooling fins (2) form a web joining the profile elements.

2. A heat sink (1) according to claim 1, wherein one of the profile elements (10:2), viewed in the width direction, is wider than the other profile elements (10:1, 10:3), and the semiconductor device (6) is mounted on an underside of the wider profile element turned away from the cooling fins (2).

3. A heat sink (1) according to claim 2, wherein the wider profile element (10:2) is arranged to a U-shaped cross section to form a bearing rail with an open channel turned away from the cooling fins (2), in which said semiconductor device (6) is mounted in a recessed manner.

4. A heat sink (1) according to anyone of claims 2-3, wherein the extent of the base (3) in the width direction is terminated by a respective outer profile element (10:1, 10:3), which, viewed in the width direction, is narrower than said wider profile element (10:2).

5. A heat sink (1) according to anyone of claims 1-4, wherein the cooling fins (2) are configured to be substantially perpendicular and transverse to the longitudinal axis of the base (3).

6. A heat sink (1) according to anyone of claims 2-5, wherein each of the two outer narrower profile elements (10:1, 10:3), viewed as volume elements, have a parallellepipedic shape with a rectangular cross section profile, the height of which exceeds the width of the profile element.

7. A heat sink (1) according to anyone of claims 1-6, wherein the wider profile element (10:2) is centrally disposed between the narrower profile elements (10:1, 10:3) in such a manner that two channels (8:1, 8:2) travelling in in parallel are delimited between said respective profile elements.

8. A heat sink (1) according to anyone of claims 1-7, wherein the cooling fins (2) have a four-sided main surface, which in both height and width direction is delimited by parallel side edges (2a, 2b, 2c, 2d), or in the width direction are delimited by side edges (2a, 2b) tilting inwards in such a manner that the cooling fins (2) are narrower at their free end than at the end facing the base (3).

9. A heat sink (1) according to anyone of claims 1-8, wherein the base (3) comprises one or a plurality of undercut tracks (13) obtained through profiling, which tracks are intended to form an engagement part for a fastener (14).

10. A heat sink (1) according to anyone of claims 1-9, which are made of aluminum or copper.

11. A heat sink (1) according to anyone of claims 1-10, wherein the cooling fins (2) are formed in block-slice pattern on the base (3), and which cooling fins can have a material thickness varying between 50µm and 3 mm.

12. A lighting fixture (20), **characterized in that** it comprises a heat sink according to anyone of claims 1-11.

13. A lighting fixture (20) according to claim 12, intended, directly or indirectly via suspension means (24), to be disposed onto a ceiling (25) in a building to provide a downward light by means of LED-PCBs.

14. A lighting fixture (20) according to anyone of claims 12-13, the heat sink (1) of which is encompassed by a bracket structure (21) comprising side pieces (22) on either short side, a plurality of elongated connection elements (23), which, joining the respective side pieces (22), are arranged to extend in the longitudinal direction of the heat sink, and said bracket structure (21) is mounted in the base portion (3) of the heat sink (1) via screw means or similar fasteners (14), which are accommodated in undercut tracks (13) in the base portion.

15. A heating fixture (20) according to claim 13, wherein each side piece (22) comprises two transverse substantially platform-like side arms (22a, 22b), and each elongated connection element (23) comprises, viewed in the cross section, a V-shaped angle brace arranged to extend along a long side edge of the heat sink (1).
